# EUROPEAN PATENT APPLICATION

(11) **EP 4 739 037 A1**
(43) Date of publication of application: **06.05.2026**
(21) Application number: 25211949.0
(22) Date of filing: 29.10.2025
(51) Int. Cl.: H10F 19/90

(54) **METHOD FOR MANUFACTURING CELL STRING, METHOD FOR MANUFACTURING PHOTOVOLTAIC MODULE, AND PHOTOVOLTAIC MODULE**

(30) Priority: 01.11.2024 CN 202411555181
(71) Applicant: JINKO SOLAR CO., LTD, ShangRao, Jiangxi 334100 (CN); Jinko Solar (Haining) Co., Ltd., Haining City, Zhejiang (CN)
(72) Inventor: TAO, Wusong, Shangrao, Jiangxi, 334100 (CN); WANG, Luchuang, Shangrao, Jiangxi, 334100 (CN); WANG, Xin, Shangrao, Jiangxi, 334100 (CN); LI, Chunqiang, Shangrao, Jiangxi, 334100 (CN); HAN, Xiangchao, Shangrao, Jiangxi, 334100 (CN)
(74) Representative: Balder IP Law, S.L.

(57) **Abstract**

A method for manufacturing a cell string, a method for manufacturing a photovoltaic module are provided. The method includes: providing a plurality of slicing cell sheets to be stacked, the plurality of slicing cell sheets include a first slicing cell sheet and a second slicing cell sheet, at least one surface of the first slicing cell sheet includes a stacking area to be stacked with the second slicing cell sheet, and a first buffer adhesive film is laid in the stacking area; laying first welding strips on the surface of the first slicing cell sheet, the first welding strip passing through the stacking area and covering a part of the first buffer adhesive film; partially stacking the second slicing cell sheet with the first slicing cell sheet; performing welding such that the second slicing cell sheet is electrically interconnected with the first slicing cell sheet via the first welding strips.

## Description

### TECHNICAL FIELD

Embodiments of the present disclosure relate to the photovoltaic field, and in particular to a method for manufacturing a cell string, a method for manufacturing a photovoltaic module, and a photovoltaic module.

### BACKGROUND

Cell string is a structure that connects multiple cell sheets in series to produce more power, preventing situations where a single cell cannot meet the desired voltage and current.

Stacked cell strings, as a type of cell strings, are formed by slicing cell sheets and interconnecting front surface edges of preceding slicing cell sheets with back surface edges of subsequent slicing cell sheets. Such a design allows the cell slices to be connected to each other in a more compact manner, and reduces gaps between the cell sheets, which can increase the power of the cell string per unit area, thereby being widely used.

However, for the stacked cell strings, there is a problem that overlapping parts of the stacked cell strings are prone to damage.

### SUMMARY

Embodiments of the present disclosure provide a method for manufacturing a cell string, a method for manufacturing a photovoltaic module, and a photovoltaic module.

According to some embodiments of the present disclosure, a method for manufacturing a cell string is provided. The method includes: providing a plurality of slicing cell sheets to be stacked, where the plurality of slicing cell sheets include a first slicing cell sheet and a second slicing cell sheet, at least one surface of the first slicing cell sheet has a stacking area to be stacked with the second slicing cell sheet, and a first buffer adhesive film is laid in the stacking area; laying first welding strips on the at least one surface of the first slicing cell sheet, with the first welding strips passing through the stacking area and covering a part of the first buffer adhesive film; partially stacking the second slicing cell sheet with the first slicing cell sheet; and performing welding such that the second slicing cell sheet is electrically interconnected with the first slicing cell sheet via the first welding strips.

In some embodiments, in an arrangement direction of the plurality of slicing cell sheets in the cell string, the first buffer adhesive film has a width greater than or equal to a width of the stacking area.

In some embodiments, in an arrangement direction of the plurality of slicing cell sheets in the cell string, the first buffer adhesive film protrudes from an end portion of the first slicing sheet.

In some embodiments, in an arrangement direction of the plurality of slicing cell sheets in the cell string, the first buffer adhesive film has a width ranging from 3 mm to 10 mm; and in a direction perpendicular to the arrangement direction of the plurality of slicing cell sheets, the first buffer adhesive film has a length ranging from 6 mm to 13 mm.

In some embodiments, the method further including: before laying the first welding strips on the surface of the first slicing cell sheet, performing a heat fixing treatment on the first buffer adhesive film, where the heat fixing treatment includes heating the first buffer adhesive film to bond the first buffer adhesive film on the surface of the first slicing cell sheet.

In some embodiments, process parameters of the heat fixing treatment include: a heating temperature ranging from 60°C to 70°C and a heating time period ranging from 0.5 s to 1.5 s.

In some embodiments, the welding includes laser welding, and the laser welding includes: controlling a laser to irradiate a surface of the first welding strips to weld the first welding strips to surfaces of the slicing cell sheets.

In some embodiments, the method further includes providing a plurality of solder joints on the slicing cell sheets, the first welding strips are in contact with the plurality of solder joints, and in an arrangement direction of the slicing cell sheets in the cell string, a width of the first buffer adhesive film is less than a distance between the two nearest solder joints of the first and second slicing cell sheets.

In some embodiments, a respective first welding strip of the first welding strips includes a main portion and a connecting portion connecting the main portions, where the main portion has a thickness greater than a thickness of the connecting portion; the laying of the first welding strips on the at least one surface of the first slicing cell sheet includes: positioning the connecting portion to be directly aligned with the first buffer adhesive film.

In some embodiments, a sum of the thickness of the connecting portion and a thickness of the first buffer adhesive film is equal to the thickness of the main portion.

In some embodiments, the first buffer adhesive film may be made from a pre-crosslinked adhesive film such as Ethylene Vinyl Acetate Copolymer (EVA), Polyolefin Elastomer (POE), or a co-extruded material of EVA-POE-EVA (EPE).

In some embodiments, the first buffer adhesive film is made from an Ethylene Vinyl Acetate Copolymer (EVA) material with a crosslinking degree of 5% to 70%, a Polyolefin Elastomer (POE) material with a crosslinking degree of 5% to 70%, or an EVA-POE-EVA (EPE) material with a crosslinking degree of 5% to 70%.

In some embodiments, a respective slicing cell sheet of the plurality of slicing cell sheets is a 3-segmented to a 12- segmented cell obtained by cutting an original whole cell sheet into 3 to 12 segments.

In some embodiments, a width of the respective slicing cell sheet ranges from 40 to 86 mm, a length of the respective slicing cell sheets ranges from 180 to 260 mm.

In some embodiments, the laying of the first buffer adhesive film includes: providing an initial buffer adhesive film; cutting the initial buffer adhesive film to form the first buffer adhesive film; and moving the first buffer adhesive film to the stacking area.

In some embodiments, the first slicing cell sheet includes a first surface and a second surface opposite to the first surface, the laying of the first buffer adhesive film includes: laying the first buffer adhesive film in the stacking area corresponding to the first surface and the second surface.

In some embodiments, the first slicing cell sheet is formed by: providing an initial cell sheet; cutting the initial cell sheet to form at least three cell slices; and laying the first buffer adhesive film in the stacking area of a respective cell slice of the at least three cell slices to form the first slicing cell sheet.

In some embodiments, the first slicing cell sheet is formed by: providing an initial cell sheet; laying the first buffer adhesive film in the stacking area of the initial cell sheet corresponding to each slicing cell sheet; and cutting the initial cell sheet with the first buffer adhesive film laid thereon to form at least three first slicing cell sheets.

In some embodiments, the plurality of slicing cell sheets include edge cell sheets with a cutting surface; the method further includes: before partially stacking the second slicing cell sheet with the first slicing cell sheet, adjusting an orientation of the cutting surfaces of the edge cell sheets so that the cutting surfaces of the edge cell sheets face the same direction.

According to some embodiments of the present disclosure, a method for manufacturing a photovoltaic module is provided. The method includes providing a plurality of cell strings, a respective cell string of the plurality of cell strings being formed by the manufacturing method in all or part of the above embodiments; laying second buffer adhesive films on surfaces of the slicing cell sheets on both sides of respective cell string, the second buffer adhesive films being located at end portions of the slicing cell sheets; providing second welding strips, the second welding strips being electrically connected to the slicing cell sheets on both sides of the respective cell string and covering surfaces of the second buffer adhesive films; providing busbars, the busbars being electrically connected to the second welding strips and electrically connected to the plurality of cell strings via the second welding strips; forming at least one encapsulating adhesive film, the at least one encapsulating adhesive film being configured to cover surfaces of the plurality of cell strings; and forming a cover plate, the cover plate being configured to cover a surface of the at least one encapsulating adhesive film facing away from the plurality of cell strings.

### BRIEF DESCRIPTION OF THE DRAWINGS

One or more embodiments are exemplarily illustrated by figures in the corresponding drawings, which do not constitute limitations on the embodiments. Unless otherwise specified, the figures in the drawings do not constitute limitations on scales. In order to illustrate the technical solutions in embodiments of the present disclosure or the technical solutions in the conventional technologies more clearly, the drawings used in the embodiments will be described briefly below. Apparently, the following described drawings are merely for the embodiments of the present disclosure, and other drawings can be derived according to the described drawings by those of ordinary skill in the art without any creative effort.
FIG. 1 is a schematic structural diagram of an initial cell sheet.
FIG. 2 is a schematic structural view of a segmented cell sheet formed on the basis of FIG. 1.
FIG. 3 is a schematic flow chart of a method for manufacturing a cell string according to an embodiment of the present disclosure.
FIG. 4 is a schematic structural view of the series connection of two adjacent slicing cell sheets.
FIG. 5 is another schematic structural view of the series connection of two adjacent slicing cell sheets.
FIG. 6 is yet another schematic structural view of the series connection of two adjacent slicing cell sheets.
FIG. 7 is a schematic structural view of a cell string according to an embodiment of the present disclosure.
FIG. 8 is a schematic structural view of another cell string according to an embodiment of the present disclosure.
FIG. 9 is an enlarged schematic structural view of the dotted circle in FIG. 8.
FIG. 10 shows second welding strips formed on the basis of FIG. 9.
FIG. 11 shows busbars formed on the basis of FIG. 10.
FIG. 12 is a cross sectional view of a photovoltaic module according to an embodiment of the present disclosure.

### DETAILED DESCRIPTION OF THE EMBODIMENTS

As can be seen from the background, when forming a cell string, laminating adjacent cell sheets is a current means to increase the power of the cell string per unit area.

In the related art, in order to alleviate the interaction force on the overlapping part of adjacent cell sheets, processes such as separating the sheets, inserting films, and heating are performed after forming the cell string so as to achieve the purpose of alleviating the interaction force between the adjacent cell sheets. However, for slicing cell sheets, through the above-mentioned processes, the slicing cell sheets will form a certain opening angle, which will cause detachment of the adhesive film, especially for the situation where an initial cell sheet is cut to form at least three slicing cell sheets. The more the number of slicing cell sheets, the smaller the size of the formed slicing cell sheets. The small-sized slicing cell sheets are more likely to be seriously affected by the sheet separating process, especially prone to causing detachment of welding strips on the slicing cell sheets, resulting in poor welding.

In the method for manufacturing the cell string provided in embodiments of the present disclosure, prior to connecting two slicing cell sheets in series, a first buffer adhesive film is laid on the surface of each slicing cell sheet, and thus during the subsequent series connection of the slicing cell sheets, the overlapping part of the adjacent slicing cell sheets is covered with the first buffer adhesive film, thereby reducing the interaction force on the overlapping part of the slicing cell sheets and avoiding defects in the overlapping part of the slicing cell sheets.

In the description of the embodiments of the present disclosure, the technical terms "first", "second", etc. are only used to distinguish different objects and cannot be understood as indicating or implying relative importance or implicitly indicating the quantity, particular order, or primary and secondary relationship of the indicated technical features. In the description of embodiments of the present disclosure, "a plurality of" means two or more than two, unless otherwise specifically defined.

When "embodiment" is mentioned herein, it means that a particular feature, structure, or characteristic described based on the embodiment can be included in at least one embodiment of the present disclosure. When appeared in various places in the specification, the phrase does not necessarily indicate the same embodiment, nor be a separate or alternative embodiment mutually exclusive of other embodiments. It is explicitly and implicitly understood by those skilled in the art that the embodiment described herein can be combined with other embodiments.

In the description of the embodiments of the present disclosure, the term "and/or" only describes the association relationship of associated objects, indicating that there may be three relationships. For example, A and/or B may indicate three conditions: A alone, both A and B, and B alone. In addition, the character "/" herein generally indicates that the relationship between the former and latter objects is an "or" relationship.

In the description of the embodiments of the present disclosure, the term "plurality" refers to at least two (including two). Similarly, "a plurality of groups" refers to at least two groups (including two groups), and "a plurality of sheets" refers to at least two sheets (including two sheets).

In the description of the embodiments of the present disclosure, it should be understood that the terms "center", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential" etc. indicate the orientations or positional relationships on the basis of the drawings. These terms are only for the convenience of describing the present disclosure and simplifying the description, rather than indicating or implying that the related devices or element must have the specific orientations, or be constructed or operated in the specific orientations, and therefore cannot be understood as limitations of the present disclosure.

In the description of the embodiments of the present disclosure, unless otherwise clearly specified and defined, the terms "installed", "connected", "coupled", "fixed" and the like should be understood broadly. For example, an element, when being referred to as being "installed", "connected", "coupled", or "fixed" to another element, unless otherwise specifically defined, may be fixedly connected, detachably connected, or integrated to the other element, may be mechanical connected or electrically connected to the other element, and may be directly connected to the other element, or connected to the other element via an intermediate medium, or may be internal communication between two elements or interaction between two elements. For those skilled in the art, the specific meanings of the above terms in the present disclosure can be understood according to specific circumstances.

In the accompanying drawings corresponding to the embodiments of the present disclosure, the thickness and area of the layers are exaggerated for better understanding and description. When describing that a component (such as a layer, a film, a region, or a substrate) is located on another component or on the surface of another component, the component may be "directly" located on the surface of the other component, or a third component may be provided between the two components. On the contrary, when describing that a component is located on the surface of another component or a component is formed or provided on the surface of another component, it means that no third component is provided between the two components. In addition, when describing that a component is "substantially" formed on another component, it means that the component is not formed on the entire surface or the front surface of the other component, nor is it formed on a partial edge of the entire surface.

In the description of the embodiments of the present disclosure, unless otherwise specified, when describing that a component "includes" another component, other components are not excluded, and other components can be further included. In addition, when describing that a component such as a layer, a film, a region, or a plate is located "on" another component, the component may be "directly on" the other component (i.e., located on the surface of the another component with no other components between them), or another component may be provided between the two components. In addition, when a component such as a layer, a film, a region, or a plate is "directly located on" another component, or when a component such as a layer, a film, a region, or a plate is located on the surface of another component, it means that no other components are located in between the two components.

The terms used in the description of the embodiments described herein are only used to describe specific embodiments and are not intended to be limiting. As used in the description of the embodiments and in the appended claims, "the component" is intended to include the plural form, unless the context clearly indicates otherwise. Among them, the component includes a layer, a film, a region, a plate, etc.

Embodiments of the present disclosure will now be described in detail with reference to the accompanying drawings. It should be understood by those of ordinary skill in the art that many technical details are described in the embodiments of the present disclosure to enable readers to better understand the present disclosure. However, even without these technical details, the technical solutions claimed in the present disclosure can also be implemented based on various changes and modifications of the following embodiments.

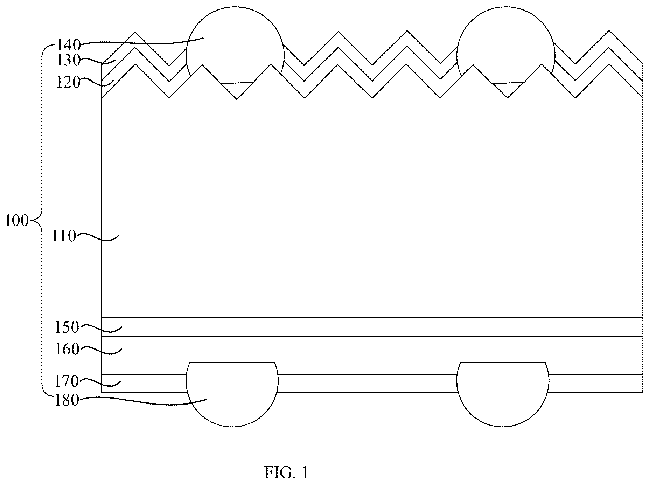

Referring to FIG. 1, FIG. 1 is a schematic structural view of an initial cell sheet. In some embodiments, a method for manufacturing a cell string may include: providing an initial cell sheet 100.

The initial cell sheet 100 includes but is not limited to one or any combination of passivated emitter rear (PERC) cells, interdigitated back contact (IBC) cells, tunnel oxide passivated contact (TOPCon) cells, heterojunction technology (HIT/HJT) cells, thin-film solar cells, and tandem cells. Among them, thin-film solar cells include but are not limited to perovskite thin-film solar cells, copper indium selenide thin-film solar cells, gallium arsenide thin-film solar cells, and cadmium sulfide thin-film solar cells. The tandem cells include but are not limited to perovskite cells stacked on crystalline silicon cells, perovskite cells stacked on perovskite cells, and perovskite cells stacked on thin-film cells.

Taking TOPCon cells as an example, the initial cell sheet 100 may include a front emitter 120, a front passivation layer 130, a front electrode 140, a back oxide layer 150, a back doped conducting layer 160, a back passivation layer 170, and a back electrode 180 formed on the surface of a substrate 110.

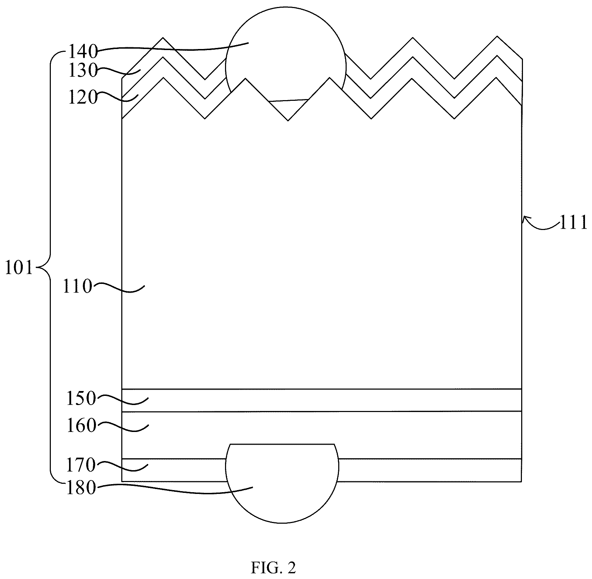

Referring to FIG. 2, FIG. 2 is a schematic structural view of a segmented cell sheet formed on the basis of FIG. 1. The method for manufacturing the cell string may further include: cutting the initial cell sheet 100 to form at least three slicing cell sheets 101.

It should be understood that, for the segmented cell sheet (also called slicing cell sheet) 101, the segmented cell sheet 101 may also include the substrate 110, the front emitter 120, the front passivation layer 130, the front electrode 140, the back oxide layer 150, the back doped conducting layer 160, the back passivation layer 170, and the back electrode 180.

In some embodiments, each of the slicing cell sheets 101 includes an edge cell sheet each having one cutting surface 111. The method further includes: before partially stacking the second slicing cell sheet with the first slicing cell sheet (i.e., before connecting the adjacent slicing cell sheets 101 in series), adjusting the orientation of the cutting surface 111 of the edge cell sheet so that the cutting surfaces 111 of the edge cell sheets are oriented in the same direction.

It should be understood that during the cutting process of the initial cell sheet, at least one cut surface 111 is formed on the formed slicing cell sheet 101. Taking the example of slicing the initial cell sheet into three slicing cell sheets 101, two slicing cell sheets 101 have one cut surface 111, which corresponds to the edge cell sheets; and the remaining slicing cell sheet 101 has two cut surfaces 111.

After forming the slicing cell sheets 101, the orientations of the cut surfaces 111 of the slicing cell sheets 101 are adjusted, so that the cut surfaces 111 of the edge cell sheets are oriented in the same direction. Taking the example of formation of three slicing cell sheets 101, the cut surfaces 111 of two slicing cell sheets 101 having only one cut surface 111 are adjusted to orientate the same side, and either of the two cut surfaces 111 of the remaining slicing cell sheet 101 having two cut surfaces 111 is adjusted to orientate the same side as the cut surfaces of the two slicing cell sheets 101 having only one cut surface 111. After forming the slicing cell sheets 101, by adjusting the orientation of the slicing cell sheets 101, it is convenient to subsequently connect the slicing cell sheets 101 in series.

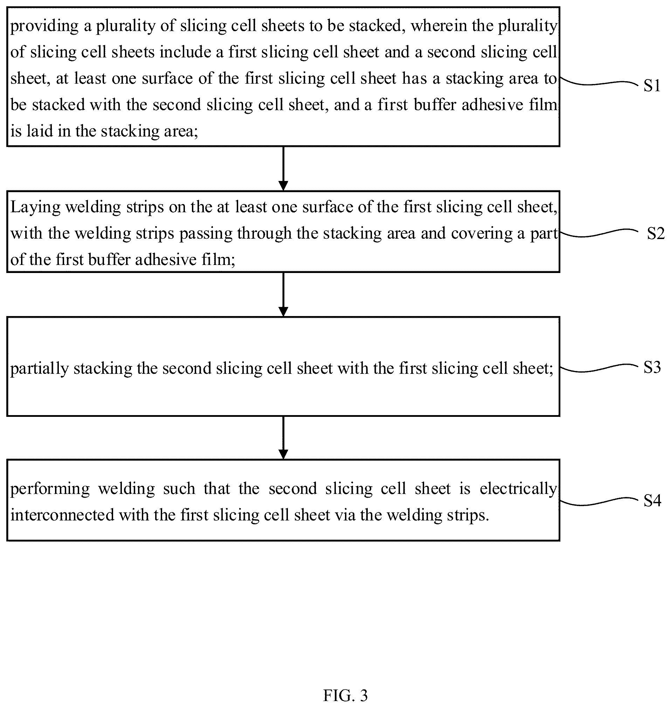

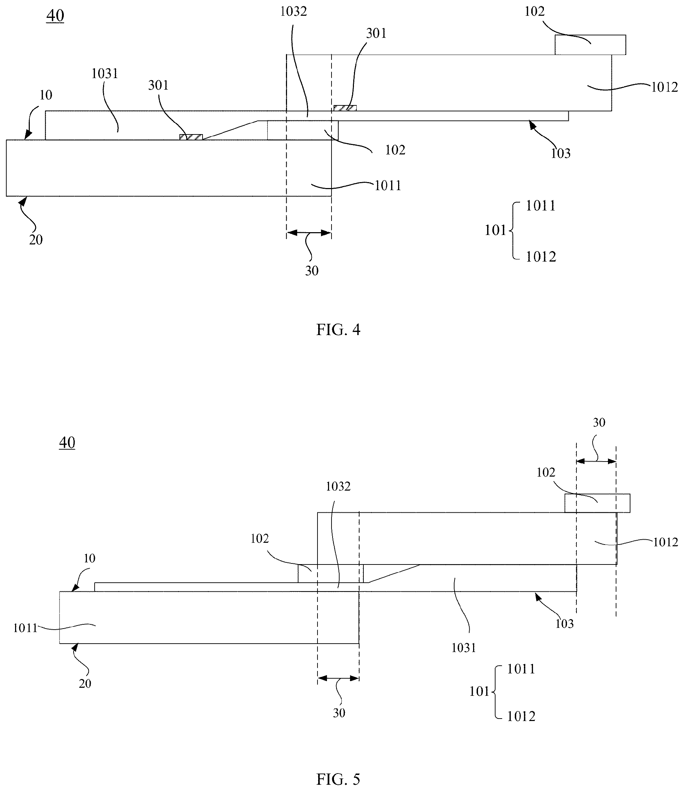

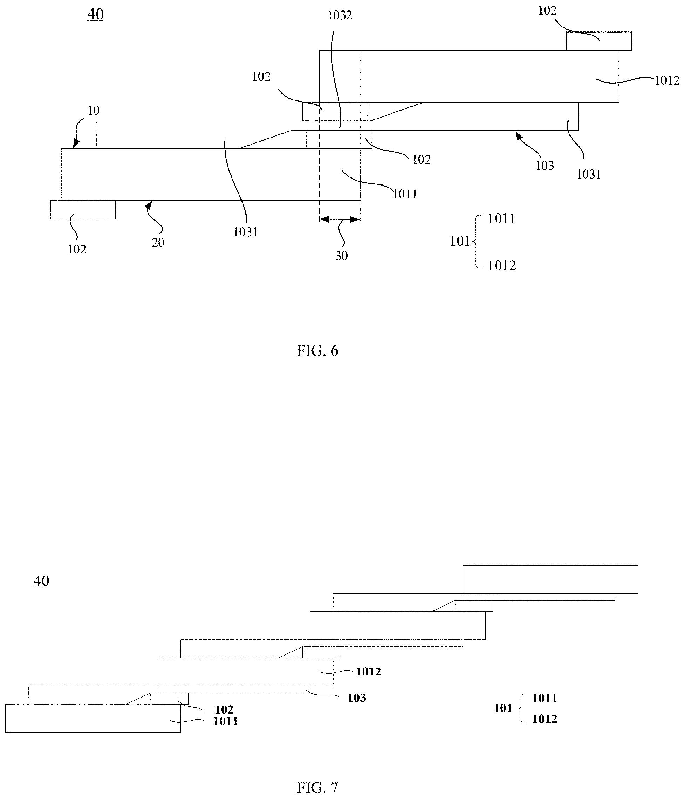

FIG. 3 is a schematic flow chart of a method for manufacturing a cell string according to an embodiment of the present disclosure. FIG. 4 is a schematic structural view of the series connection of two adjacent slicing cell sheets. FIG. 5 is another schematic structural view of the series connection of two adjacent slicing cell sheets. FIG. 6 is yet another schematic structural view of the series connection of two adjacent slicing cell sheets.

As shown in FIG. 3 to FIG. 6, the method for manufacturing the cell string according to an embodiment of the present disclosure specifically includes the following steps.

S1, a plurality of slicing cell sheets to be stacked are provided, and the plurality of slicing cell sheets include a first slicing cell sheet and a second slicing cell sheet. At least one surface of the first slicing cell sheet has a stacking area that is to be stacked with the second slicing cell sheet, and a first buffer adhesive film is laid in the stacking area.

During the series connection of multiple slicing cell sheets 101, two adjacent slicing cell sheets are arranged in an edge-overlapping configuration. The area where the second slicing cell sheet 1012 directly faces the first slicing cell sheet 1011 serves as the edge-overlapping region of the two adjacent slicing cell sheets 101, which is also referred to as the stacking area 30. The width of this stacking area 30 typically ranges from 0.3mm to 2mm, with specific values including 0.36mm, 0.4mm, 0.5mm, 1mm, or 1.5mm.

In some embodiments, during the manufacture of the cell string 40, a certain number of the slicing cell sheets 101 are stacked with one another and connected in series. Throughout the embodiments of the present disclosure, the first slicing cell sheet 1011 is introduced to denote any random slicing cell sheet in the cell string 40, rather than a specific one among the plurality of slicing cell sheets 101. For example, when processing each pair of adjacent slicing cell sheets to be stacked in a certain stacking order, one slicing cell sheet may be selected as the first slicing cell sheet 1011, and the next slicing cell sheet adjacent to the first slicing cell sheet 1011 may be referred to as the second slicing cell sheet 1012. When processing the second slicing cell sheet and a third slicing cell sheet adjacent to the second slicing cell sheet, the second and third slicing cell sheets form a new set of adjacent slicing cell sheets; in this case, the second slicing cell sheet 1012 from the previous set is referred to as the first slicing cell sheet in the new set of adjacent slicing cell sheets. For example, there are three adjacent slicing cell sheets A, B, and C, where slicing cell sheet A is adjacent to slicing cell sheet B, and slicing cell sheet B is adjacent to slicing cell sheet C. When stacking and welding slicing cell sheets A and B, the first slicing cell sheet to be processed (i.e., slicing cell sheet A) is referred to as the first slicing cell sheet 1011, and slicing cell sheet B is referred to as the second slicing cell sheet 1012. Similarly, when stacking and welding slicing cell sheets B and C, slicing cell sheet B is referred to as the first slicing cell sheet 1011, and slicing cell sheet C is referred to as the second slicing cell sheet 1012. In the embodiments of the present disclosure, the first slicing cell sheet 1011 is not intended to refer to a specific slicing cell sheet and may denote any random slicing cell sheet to be welded except the last one in the cell string.

In some embodiments, referring to FIGS. 5 and 6, the slicing cell sheets 101 each include a first surface 10 (e.g., a front surface) and a second surface 20 (e.g., a back surface) that are opposite to each other, and first buffer adhesive films 102 are positioned on opposite sides of the slicing cell sheet 101. For example, one first buffer adhesive film 102 is located in the stacking area 30 on the first surface 10 of the first slicing cell sheet 1011, while the other first buffer adhesive film 102 is located in the stacking area 30 on the second surface 20 of the first slicing cell sheet 1011. It should be understood that in the overlapping portion of two adjacent slicing cell sheets 101, one slicing cell sheet 101 sits on the top surface of the other. Consequently, for these two adjacent slicing cell sheets 101, one experiences force on the front surface of the slicing cell sheet 101, and the other endures force on the back surface of the slicing cell sheet 101. Thus, arranging the first buffer adhesive films 102 on both sides of the slicing cell sheet 101 can better protect the slicing cell sheet 101.

Referring to FIG. 4, in some embodiments, the slicing cell sheets 101 each include a first surface 10 (e.g., a front surface) and a second surface 20 (e.g., a back surface) that are opposite to each other, and the first buffer adhesive film 102 may be arranged on only one side of the slicing cell sheet 101. For example, the first buffer adhesive film 102 is located in the stacking area 30 on the first surface 10 of the first slicing cell sheet 1011. Compared with the solution where the first buffer adhesive films 102 are located on the opposite sides of the first slicing cell sheet 1011, this solution has simpler process steps. Moreover, there is no need to consider how to fix the first buffer adhesive film 102 on the second surface 20 of the slicing cell sheet 101, thereby reducing the process difficulty of the manufacturing method for the cell string 40.

S2, first welding strips are laid on the surface of the first slicing cell sheet, passing through the stacking area and covering a part of the first buffer adhesive film.

In some embodiments, the first welding strips 103 are laid on the first surface 10 of the first slicing cell sheet 1011. The extending direction of the first welding strips 103 is parallel to the arrangement direction of the plurality of slicing cell sheets 101 in the cell string 40, and each welding strip 103 passes through the stacking area 30 and covers part of the first buffer adhesive film 102.

S3, the second slicing cell sheet is partially stacked with the first slicing cell sheet, and the first buffer adhesive film is sandwiched between the second slicing cell sheet and the first slicing cell sheet.

In some embodiments, referring to FIG. 4, after the second slicing cell sheet 1012 is partially stacked with the first slicing cell sheet 1011, the first buffer adhesive film 102 is sandwiched between the first welding strips 103 and the first slicing cell sheet 1011. In this scenario, the first welding strips 103 and the first slicing cell sheet 1011 are isolated from each other, as the first buffer adhesive film 102 is present in the stacking area 30 of the first slicing cell sheet 1011.

In some embodiments, referring to FIG. 5, after the second slicing cell sheet 1012 is partially stacked with the first slicing cell sheet 1011, the first buffer adhesive film 102 is sandwiched between the first welding strips 103 and the second slicing cell sheet 1012. In this scenario, the first welding strips 103 and the second slicing cell sheet 1012 are isolated from each other, as the first buffer adhesive film 102 is present in the stacking area 30 of the second slicing cell sheet 1012.

In some embodiments, referring to FIG. 6, after the second slicing cell sheet 1012 is partially stacked with the first slicing cell sheet 1011, one first buffer adhesive film 102 is sandwiched between the first welding strips 103 and the first slicing cell sheet 1011, and another first buffer adhesive film 102 is sandwiched between the first welding strips 103 and the second slicing cell sheet 1012. In this scenario, the first welding strips 103 is isolated from the first slicing cell sheet 1011 and the second slicing cell sheet 1012 simultaneously, as the first buffer adhesive films 102 are present in the stacking areas 30 of the first and second slicing cell sheets.

S4, welding is performed to electrically interconnect the second slicing cell sheet and the first slicing cell sheet via the first welding strips.

In some embodiments, the first welding strips 103 may first be welded to the first slicing cell sheet 1011. Then, after the second slicing cell sheet 1012 is stacked with the first slicing cell sheet 1011, the first welding strips 103 are welded to the second slicing cell sheet 1012. This configuration enables electrical interconnection between the second slicing cell sheet 1012 and the first slicing cell sheet 1011 via the first welding strips 103.

In some embodiments, after the second slicing cell sheet 1012 is stacked with the first slicing cell sheet 1011, the first welding strips 103 may be welded to the first slicing cell sheet 1011 and the second slicing cell sheet 1012 in a single operation. Embodiments of the present disclosure do not limit the sequence of this welding sequence.

In the embodiments of the present disclosure, by introducing a butter adhesive film 102 pre-laid in the stacking area 30 of slicing cell sheets 101 before the slicing cell sheets 101 are stacked and serially connected. This pre-arrangement ensures the first buffer adhesive film 102 is positioned in the overlapping portion of the first slicing cell sheet 1011 and the second slicing cell sheet 1012 during their subsequent serial connection, creating a protective layer between the first slicing cell sheet 1011 and the second slicing cell sheet 1012. Specifically, by first placing the first buffer adhesive film 102 and the first welding strips 103 on a slicing cell sheet, then stacking the next slicing cell sheet prior to conducting the welding process, this manufacturing sequence avoids the detachment of pre-welded strips. Such detachment is a common technical issue in conventional techniques that involve sheet breaking and film inserting operations. Consequently, the interaction force exerted on the overlapping portion of the first slicing cell sheet 1011 and the second slicing cell sheet 1012 during the subsequent welding process is significantly reduced, thereby effectively preventing abnormalities in the overlapping portion and substantially lowering the number of cell strings with welding defects.

In some embodiments, referring to FIG. 4, in an arrangement direction of the plurality of slicing cell sheets 101 in the cell string 40, a width of the first buffer adhesive film 102 is greater than or equal to a width of the stacking area 30. Specifically, the width of the first buffer adhesive film 102 may be larger than that of the stacking area 30 in this direction.

In some embodiments, the first buffer adhesive film 102 protrudes beyond an end portion of the slicing cell sheet 101. Specifically, in an arrangement direction of the plurality of slicing cell sheets 101 in the cell string 40, the first buffer adhesive film 102 has a total width of 4 mm, with 1.5 mm protruding beyond the edge of the slicing cell sheet 101, and the remaining 2.5 mm is in contact with the first surface 10 of the slicing cell sheet 101. It should be understood that each of the slicing cell sheets 101 has edges; compared to the first surface 10 and the second surface 20 of each of the slicing cell sheets 101, these edges are more susceptible to deformation and damage when force is applied. For example, in one implementation, by configuring the first buffer adhesive film 102 to protrude 1.5mm beyond the end of each of the slicing cell sheets 101 while maintaining 2.5mm of contact with the first surface 10, the first buffer adhesive film 102 can effectively protect the edges of each of the slicing cell sheets 101, thereby further improving the reliability of the cell string 40.

In an arrangement direction of the plurality of slicing cell sheets 101 in the cell string 40, a width of the first buffer adhesive film 102 ranges from 3 mm to 10 mm, for example, 4 mm, 5 mm, 6 mm, 7 mm, 8 mm, or 9 mm, etc. In a direction perpendicular to the arrangement direction of the plurality of slicing cell sheets 101, a length of the first buffer adhesive film 102 ranges from 6 mm to 13 mm, for example, 7 mm, 8 mm, 9 mm, 10 mm, 11 mm, or 12 mm, etc. As for the width and the length of the first buffer adhesive film 102, the larger the width and length of the first buffer adhesive film 102, the larger the area of the slicing cell sheet 101 that can be protected by the first buffer adhesive film 102. Similarly, the larger the width and length of the first buffer adhesive film 102, the higher the cost of the first buffer adhesive film 102, and the reliability of the connection between the slicing cell sheet 101 and the first welding strips 103 can be affected. Therefore, the width of the first buffer adhesive film 102 is set to 3mm to 10 mm and the length of the first buffer adhesive film 102 is set to 6 mm to 13 mm, which can not only take into account the protection performance of the first buffer adhesive film 102, but also avoid the impact of the first buffer adhesive film 102 on the reliability of the cell string 40.

In some embodiments, the length of the first buffer adhesive film 102 may be less than the distance between two adjacent first welding strips in the slicing cell sheet 101. This segmented arrangement of the first buffer adhesive film 102 prevents the first buffer adhesive film 102 from interfering with the connection between the first welding strips 103 and the slicing cell sheet 101, thereby avoiding any negative impact on the reliability of the cell string 40.

In some embodiments, the length of the first buffer adhesive film 102 may also be equal to the length of the slicing cell sheet 101. For such an elongated first buffer adhesive film 102 configured as a single continuous strip, the longer the length of the first buffer adhesive film 102, the stronger the ability to protect the slicing cell sheet 101. By setting the length of the first buffer adhesive film 102 to be equal to the length of the slicing cell sheet 101, the edges and corners of the slicing cell sheet 101 can also be protected, thereby reducing the probability of damage to the slicing cell sheet 101.

In some embodiments, prior to step S2, the method for manufacturing the cell string may further include performing a heat-fixing treatment. The heat-fixing treatment includes heating the first buffer adhesive film 102 to bond the first buffer adhesive film 102 to the surface of the first slicing cell sheet 1011. By performing the heat-fixing treatment after laying the first buffer adhesive film 102, preliminary fixation may be formed between the first buffer adhesive film 102 and the first slicing cell sheet 1011. This preliminary fixation prevents the first buffer adhesive film 102 from detaching or moving during the subsequent serial connection of the first slicing cell sheet 1011 and the second slicing cell sheet 1012-if the first buffer adhesive film 102 moved during this process, it would cause welding abnormalities. Consequently, defects in the welding process are avoided, the reliability of the cell string manufacturing method is improved, and the reliability of the resulting cell string is enhanced.

For the heat fixing treatment, process parameters of the heat fixing treatment include: a heating temperature ranging from 60°C to 70°C, such as 61°C, 63°C, 65°C, 66°C, 68°C, or 69°C, etc., and a heating period ranging from 0.5s to 1.5s, such as 0.7s, 0.9s, 1s, 1.2s, or 1.4s, etc. It should be understood that for the first buffer adhesive film 102, a higher heating temperature results in tighter bonding between the first buffer adhesive film 102 and the slicing cell sheet 101. However, the higher the heating temperature, the more likely the first buffer adhesive film 102 would be damaged. The lower the heating temperature, the worse the bonding between the first buffer adhesive film 102 and the slicing cell sheet 101, which can cause detachment of the first buffer adhesive film 102 in the subsequent manufacturing process of the cell string 40. Therefore, the heating temperature is set to 60°C to 70°C, which not only takes the heating effect into account, but also avoids the impact on the first buffer adhesive film 102.

Similarly, for the heating time period, the longer the heating time period, the tighter the bonding between the first buffer adhesive film 102 and the slicing cell sheet 101. However, the longer the heating time period, the more likely the first buffer adhesive film 102 would be damaged. The shorter the heating time period, the worse the bonding between the first buffer adhesive film 102 and the slicing cell sheet 101, which can cause detachment of the first buffer adhesive film 102 in the subsequent manufacturing process of the cell string. Therefore, the heating time period is set to 0.5 s to 1.5 s, which not only takes the heating effect into account, but also avoids the impact on the first buffer adhesive film 102. By controlling the process duration time of the heat fixing treatment, the manufacturing cost of the cell string is controlled.

In some embodiments, the first buffer adhesive film 102 may be made from a pre-crosslinked film such as ethylene vinyl acetate copolymer (EVA), polyolefin elastomer (POE), EVA-POE-EVA co-extruded material (EPE), etc. By controlling the first buffer adhesive film 102 to be a pre-crosslinked film, the high temperature resistance of the first buffer adhesive film 102 can be improved, and the first buffer adhesive film 102 can be prevented from being affected in the entire process, thereby further improving the reliability of the formed cell string.

In some embodiments, the first buffer adhesive film 102 may be made from an EVA material with a crosslinking degree of 5% to 70%, a POE material with a crosslinking degree of 5% to 70%, or an EPE material with a crosslinking degree of 5% to 70%.

It should be noted that the higher the crosslinking degree, the higher the cohesive strength of the first buffer adhesive film 102 and the tighter the bonding between the first buffer adhesive film 102 and the slicing cell sheet 101. However, the higher the crosslinking degree, the harder the first buffer adhesive film 102 material, reducing the buffering capacity of the first buffer adhesive film 102. Therefore, by setting the crosslinking degree of the material to 5% to 70%, the reliability of the connection between the first buffer adhesive film 102 and the slicing cell sheet 101 can be improved while avoiding affecting the buffering capacity of the first buffer adhesive film 102.

Moreover, as for the cross-linking degree, the higher the cross-linking degree, the stronger the resistance to thermal aging of the material. When the first welding strips 103 and the cell sheets are connected through high-temperature welding, the cross-linking degree of the first buffer adhesive film 102 material can be appropriately increased to avoid thermal aging of the first buffer adhesive film 102 during the manufacturing process and to avoid excessive impact on the lifetime of the first buffer adhesive film 102.

In S4, the welding includes laser welding. The laser welding includes controlling a laser to irradiate a surface of the first welding strips 103 to weld the first welding strips 103 to a surface of the slicing cell sheet. It should be understood that the laser welding is performed by using a laser to irradiate, forming an instantaneous high temperature at the contact interface between the first welding strips 103 and the slicing cell sheet 101, so as to fix the first welding strips 103 on the slicing cell sheet 101. Moreover, the laser welding method does not cause much impact on the first buffer adhesive film 102 due to the instantaneous high temperature. Therefore, the laser welding method can reduce the impact on the first buffer adhesive film 102, thereby lowing the requirements on the material of the first buffer adhesive film 102, and reducing the difficulty and cost of the entire manufacturing method.

In other embodiments, high-temperature welding may be employed to establish the electrical connection between the adjacent first slicing cell sheet 1011 and second slicing cell sheet 1012 via the first welding strips 103. Additionally, various alternative welding techniques, such as ultrasonic welding, resistance welding, or soldering are also suitable for achieving this electrical connection. Embodiments of the present disclosure do not specifically limit the type of welding method employed, provided that the method ensures the formation of a reliable series electrical connection and stable mechanical bonding between the first slicing cell sheet 1011 and the second slicing cell sheet 1012 (where the two sheets are connected via the first welding strips 103). Meanwhile, the welding process is further required not to cause excessive damage to the structural integrity or performance of the slicing cell sheets 101. The specific selection of an appropriate welding method may be determined based on the actual application scenario, production conditions, and performance requirements of the cell string assembly.

In some embodiments, as shown in FIG. 4, the slicing cell sheets 101 are provided with solder joints 301, and the first welding strips 103 are in contact with the solder joints 301. In the arrangement direction of the plurality of slicing cell sheets 101 in the cell string 40, the width of the first buffer adhesive film 102 is smaller than the distance between the two nearest solder joints 301 respectively located on the first slicing cell sheet 1011 and the second slicing cell sheet 1012. Providing solder joints 301 on the slicing cell sheets 101 facilitates the connection between the slicing cell sheets 101 and the first welding strips 103. By setting the width of the first buffer adhesive film 102 to be smaller than the distance between the two nearest solder joints of adjacent slicing cell sheets, the first buffer adhesive film 102 can be prevented from covering the solder joints on the slicing cell sheets, and the first buffer adhesive film 102 can thus be prevented from interfering with the connection between the first welding strips 103 and the solder joints, thereby improving the reliability of the formed cell string 40.

In some embodiments, the distance between the two nearest solder joints 301 on adjacent slicing cell sheets 101 may range from 6 mm to 18 mm, for example, 7 mm, 8 mm, 12 mm, 16 mm, 17 mm, etc. It should be understood that the smaller the distance between the two nearest solder joints 301 on adjacent slicing cell sheets 101, the smaller the space reserved for disposing the first buffer adhesive film 102, resulting in increasing the difficulty of disposing the first buffer adhesive film 102, because the smaller the reserved space, the greater the difficulty of positioning the first buffer adhesive film 102, as a smaller reserved space complicates accurate placement. However, an excessively large distance between the two nearest solder joints 301 on adjacent slicing cell sheets 101 reduces the reliability of the connection between the first welding strips 103 and the slicing cell sheets 101. Therefore, setting the distance between the two nearest solder joints 301 on adjacent slicing cell sheets 101 to 6 mm to 18 mm balances the reliability of the connection between the first welding strips 103 and the slicing cell sheets 101 the space required for disposing the first buffer adhesive film 102.

In some embodiments, each first welding strip 103 may include a main portion 1031 and a connecting portion 1032 that connects the main portion 1031. The thickness of the main portion 1031 is greater than the thickness of the connecting portion 1032. The connecting portion 1032 is directly aligned with the overlapping part of the slicing cell sheet 101. Illustratively, as shown in FIG. 6, each first welding strip 103 may include two main portions 1031 and a connecting portion 1032 that connects the two main portions 1031. In other words, the first welding strip 103 has a structure that is thick at both ends and thin in the middle. This structure adapts to the connection between the first slicing cell sheet 1011 and the second slicing cell sheet 1012 and avoids excessive warping of the overlapping part of the first slicing cell sheet 1011 and the second slicing cell sheet 1012, thereby reducing the possibility of defects in the formed cell string.

It should be understood that FIG. 4 shows the first buffer adhesive film 102 arranged only on one side of slicing cell sheet 101, and the morphologies of the two main portions 1031 and the connecting portion 1032 of the first welding strip 103 may be adjusted accordingly with reference to the structures shown in FIGS. 4 to 6.

In some embodiments, the sum of the thickness of the connecting portion 1032 and the thickness of the first buffer adhesive film 102 is equal to the thickness of the main portion 1031. This configuration ensures that the gap between the first slicing cell sheet 1011 and the second slicing cell sheet 1012 remains consistent in both the stacking area 30 and the areas outside the stacking area 30, thereby preventing abnormal warping or bulging.

In some embodiments, each slicing cell sheet among the plurality of slicing cell sheets is a 3-segmented to a 12-segmented cell, obtained by cutting an original whole cell sheet into 3 to 12 segments.

For example, in some embodiments, the first slicing cell sheet 1011 may be formed by: providing an original cell sheet; cutting the original cell sheet to form at least three cell slices; and laying the first buffer adhesive film 102 in the stacking area 30 of a respective cell slice of the at least three cell slices to form the first slicing cell sheet 1011.

For example, in some embodiments, the slicing cell sheets 101 may be formed by cutting a single original cell sheet, with at least three such sheets produced by cutting the same original sheet at least twice. The greater the number of slicing cell sheets 101 obtained from the same original sheet, the higher the risk of damage caused by mutual forces between these slicing cell sheets 101. Therefore, laying the first buffer adhesive film 102 in the stacking area 30 of the slicing cell sheets 101 can effectively mitigate this problem. When the slicing cell sheets 101 include edge cell slices with one cut surface, the method further includes: before partially stacking the second slicing cell sheet 1012 and the first slicing cell sheet 1011, adjusting the orientation of the cut surfaces of the edge cell slices so that the cut surfaces of the edge cell slices face the same direction. In other embodiments, the slicing cell sheets 101 may be made by cutting multiple original cell sheets, and embodiments of the present disclosure do not limit these variations.

In some embodiments, the width of each slicing cell sheet 101 may range from 40 mm to 86 mm, for example, 61 mm, 65 mm, 70 mm, 76 mm, 77 mm, or 79 mm. The length of each slicing cell sheet 101 may range from 180 mm to 260 mm, for example, 182.3 mm, 191 mm, 200 mm, 210 mm, 223 mm, 230 mm, or 240 mm. Moreover, within the same cell string 40, the sizes of the plurality of slicing cell sheets 101 are equal, or the dimensions of their long sides or short sides fall within a preset range.

In some embodiments, laying the first buffer adhesive film 102 may include: providing an initial buffer adhesive film; cutting the initial buffer adhesive film (not shown) to form the first buffer adhesive film 102; and moving the first buffer adhesive film 102 to the stacking area 30 of the first slicing cell sheet 1011. This method allows real-time adjustment of the size of the first buffer adhesive film 102 according to the size of the stacking area 30 of the first slicing cell sheet 1011. Compared with pre-cutting solutions, this method enables more precise control over the size of the required first buffer adhesive film 102, facilitating better matching between the first buffer adhesive film 102 and the first slicing cell sheet 1011 for more accurate adaptation.

In some embodiments, the method may further include: before cutting the initial buffer adhesive film, scanning the first slicing cell sheet 1011 to obtain the dimensions of the first slicing cell sheet 1011, and feeding back the dimensions of the first slicing cell sheet 1011 to the machine that cuts the initial buffer adhesive film. This enables the machine to cut the initial buffer adhesive film into the first buffer adhesive film 102 of the required size. Thus, even when the first slicing cell sheet 1011 has dimensional deviations, the first buffer adhesive film 102 of the required size can still be well cut.

In some embodiments, laying the first buffer adhesive film 102 may include transporting the first buffer adhesive film 102 to the top or bottom of the slicing cell sheet 101, and then fixing the first buffer adhesive film 102 to the surface of the slicing cell sheet by means of vacuum adsorption.

In some embodiments, as shown in FIG. 6, the first slicing cell sheet 1011 includes a first surface 10 and a second surface 20 that are opposite to each other, and laying the first buffer adhesive film 102 includes laying the first buffer adhesive films 102 in the stacking areas 30 corresponding to the first surface 10 and the second surface 20.

In some embodiments, before cutting the original cell sheet, the first buffer adhesive film 102 may first be fixed to the original cell sheet, and then the original cell sheet is cut.

In some embodiments, forming the first slicing cell sheet 1011 may further include: providing an original cell sheet; laying the first buffer adhesive film 102 in the stacking area of the original cell sheet that corresponds to each slicing cell sheet; and cutting the original cell sheet with the first buffer adhesive film 102 laid thereon to form at least three first slicing cell sheets 101.

The technical solutions provided in the embodiments of the present disclosure has at least the following advantages. By introducing a butter adhesive film pre-laid in the stacking area of slicing cell sheets before the slicing cell sheets are stacked and serially connected. This pre-arrangement ensures the first buffer adhesive film is positioned in the overlapping portion of the first slicing cell sheet and the second slicing cell sheet during their subsequent serial connection, creating a protective layer between the first slicing cell sheet and the second slicing cell sheet. Specifically, by first placing the first buffer adhesive film and the first welding strips on a slicing cell sheet, then stacking the next slicing cell sheet prior to conducting the welding process, this manufacturing sequence avoids the detachment of pre-welded strips. Such detachment is a common technical issue in conventional techniques that involve sheet breaking and film inserting operations. Consequently, the interaction force exerted on the overlapping portion of the first slicing cell sheet and the second slicing cell sheet during the subsequent welding process is significantly reduced, thereby effectively preventing abnormalities in the overlapping portion and substantially lowering the number of cell strings with welding defects.

Another embodiment of the present disclosure further provides a method for manufacturing a photovoltaic module. The method for manufacturing the photovoltaic module may include the above-mentioned method for manufacturing the cell string. The method for manufacturing a photovoltaic module according to another embodiment of the present disclosure will be described below in conjunction with the drawings. It should be noted that the same or corresponding parts in the aforementioned embodiments can refer to the corresponding description in the aforementioned embodiments and will not be repeated below.

Referring to FIGS. 7 to 12, FIGS. 7 to 12 are schematic structural views corresponding to operations of the method for manufacturing a photovoltaic module according to an embodiment of the present disclosure.

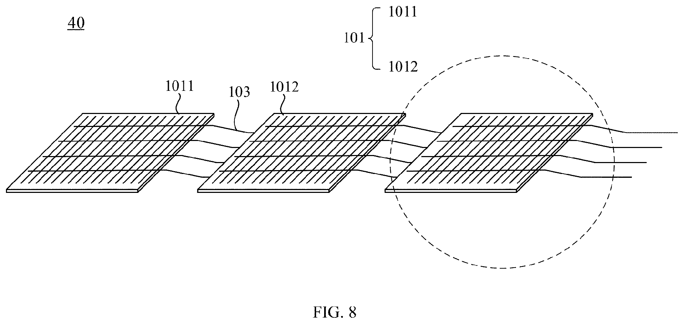

Referring to FIGS. 7 and 8, FIG. 7 is a schematic structural view of a cell string according to an embodiment of the present disclosure, and FIG. 8 is a schematic structural view of another cell string according to an embodiment of the present disclosure. In some embodiments, the method for manufacturing the photovoltaic module may include providing a plurality of cell strings 40, each cell string 40 including a plurality of slicing cell sheets 101, and first welding strips 103 connecting the plurality of slicing cell sheets 101 in series.

The cell string 40 may be formed by the manufacturing method in all or part of the above embodiments, which will not be described in detail below.

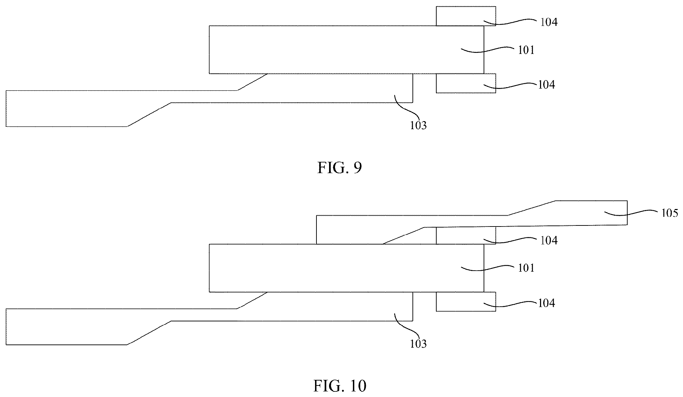

Referring to FIG. 9, FIG. 9 is an enlarged schematic structural view of the dotted circle in FIG. 8, and a second buffer adhesive film is formed on the basis of FIG. 8. The method for manufacturing the photovoltaic module may further include: laying second buffer adhesive films 104 on surfaces of the slicing cell sheets 101 at both sides of the cell string 40, and the second buffer adhesive films 104 are located at end portions of the slicing cell sheets 101. As for the cell string 40, the cell string 40 needs second welding strips 105 to electrically connect the cell string 40 to the busbars 106. For the photovoltaic module, the edges of the photovoltaic module are actually the edges of the cell strings 40, and the edges of the photovoltaic module can be deformed, resulting in abnormal photovoltaic module. Therefore, the second buffer adhesive films 104 are laid on the surfaces of the slicing cell sheets 101 at both sides of the cell string 40. On the one hand, the force on the slicing cell sheet 101 at the side of the cell string 40 adjacent to the adjacent cell string 40 is reduced when the cell strings 40 are connected in series or in parallel, thereby improving the reliability of the formed photovoltaic module. On the other hand, the force on the slicing cell sheet 101 at the edge of the photovoltaic module can be reduced, thereby reducing the possibility of damage to the edge of the photovoltaic module.

It should be understood that after laying the second buffer adhesive films 104 on the surfaces of the slicing cell sheets 101, a heat fixing treatment may be performed. The second buffer adhesive films 104 may be fixed on the slicing cell sheets 101 at both sides of the cell string 40 through the heat fixing treatment, thereby avoiding detachment of the second buffer adhesive film 104 in the subsequent manufacturing process, and improving the reliability of the photovoltaic module manufacturing process.

It should be noted that the heat fixing treatment applied to the second buffer adhesive films 104 may be the same as the heat fixing treatment applied in the above embodiments. The corresponding description can refer to the description of the heat fixing treatment in the above embodiments, which will not be described in detail below.

In some embodiments, during the laying the second buffer adhesive films 104, the second buffer adhesive films 104 may be formed on both the front and back surfaces of the slicing cell sheet 101 on the same side. For the cell strings 40, some of the cell strings 40 are electrically connected to the second welding strips 105 via the front surfaces thereof, while some of the cell strings 40 are electrically connected to the second welding strips 105 via the back surfaces thereof. By forming the second buffer adhesive films 104 on both the front and back surfaces of the slicing cell sheet 101 at the edge of the cell string 40, the process of manufacturing the photovoltaic module can be simplified, since there is no need to distinguish which cell strings are electrically connected to the second welding strips 105 via the front surfaces thereof and which cell strings electrically connected to the second welding strips 105 via the back surfaces thereof.

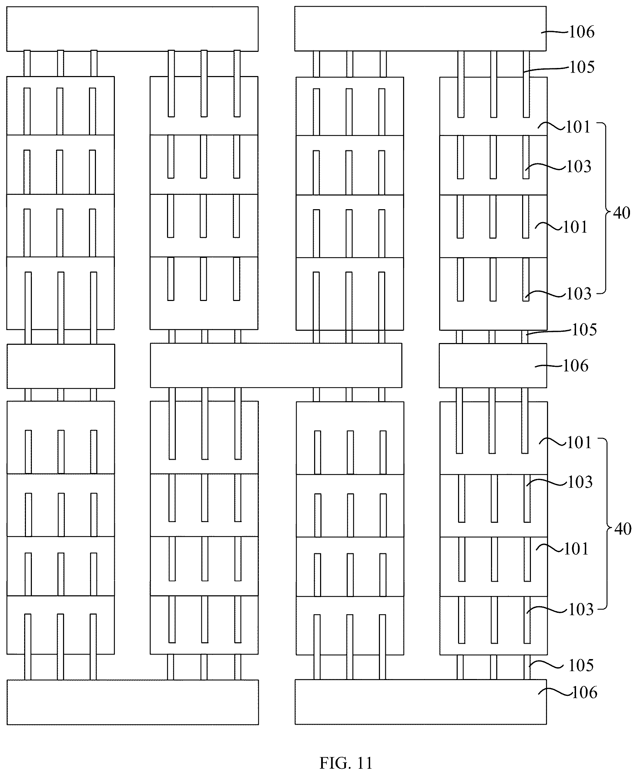

Referring to FIGS. 10 and 11, FIG. 10 shows second welding strips formed on the basis of FIG. 9, and FIG. 11 shows busbars formed on the basis of FIG. 10. It should be noted that for clearly showing the figure, FIG. 11 does not show the structure of the second buffer adhesive film.

In some embodiments, the method for manufacturing a photovoltaic module may further include: providing second welding strips 105, and providing busbars 106. The second welding strips 105 are electrically connected to the slicing cell sheets 101 at both sides of the cell string 40, and the second welding strips 105 cover surfaces of the second buffer adhesive films 104. The busbars 106 are electrically connected to the second welding strips 105 to be electrically connected to the plurality of cell strings 40 through the second welding strips 105. The second welding strips 105 are used to lead out the connection port of the circuit of the cell string 40, so as to facilitate the connection between the cell string 40 and the busbars 106. The busbars 106 are used to cooperate with the second welding strips 105 to connect different cell strings 40 in series or in parallel, so as to facilitate the control of the output voltage and the output current of the photovoltaic module.

The second welding strips 105 may be electrically connected to the slicing cell sheet 101 by laser welding. The laser welding method can reduce the impact on the second buffer adhesive film 104, thereby lowing requirements on the material of the second buffer adhesive film 104, and reducing the difficulty and cost of the entire manufacturing method.

It should be noted that the laser welding process for electrically connecting the second welding strips 105 to the slicing cell sheet 101 can be the same as the laser welding process used in the above embodiments. The corresponding description can refer to the description of the laser welding process in the above embodiments, which will not be repeated below.

In other embodiments, high-temperature welding may be employed to establish the electrical connection between the second welding strips 105 and the slicing cell sheets 101. Additionally, various alternative welding techniques, such as ultrasonic welding, resistance welding, or soldering are also suitable for achieving this electrical connection. Embodiments of the present disclosure do not specifically limit the type of welding method employed, provided that the method ensures the formation of a reliable series electrical connection and stable mechanical bonding between the second welding strips 105 and the slicing cell sheets. Meanwhile, the welding process is further required not to cause excessive damage to the structural integrity or performance of the slicing cell sheets. The specific selection of an appropriate welding method may be determined based on the actual application scenario, production conditions, and performance requirements of the cell string assembly.

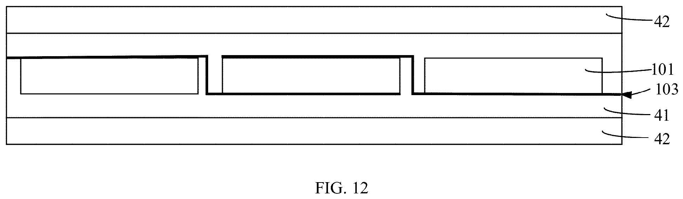

Referring to FIG. 12, FIG. 12 is a cross sectional view of a photovoltaic module according to an embodiment of the present disclosure. In some embodiments, the method for manufacturing a photovoltaic module may further include: forming at least one encapsulating adhesive film 41, and forming a cover plate 42. The at least one encapsulating adhesive film 41 is configured to cover the surface of the cell string 40. The cover plate 42 is configured to cover the surface of the at least one encapsulating adhesive film 41 facing away from the cell string 40.

In some embodiments, the at least one encapsulating adhesive film 41 includes a first encapsulating adhesive film and a second encapsulating adhesive film. The first encapsulating adhesive film covers either of the front surface and the back surface of the cell string 40. The second encapsulating adhesive film covers the other of the front surface and the back surface of the cell string 40. Specifically, either of the first encapsulating adhesive film and the second encapsulating adhesive film can be an organic encapsulating adhesive film, such as a polyvinyl butyral (PVB) adhesive film, an ethylene-vinyl acetate copolymer (EVA) adhesive film, a polyethylene octene co-elastomer (POE) adhesive film, a polyethylene terephthalate (PET) adhesive film, etc.

In some embodiments, there is a boundary line between the first encapsulating adhesive film and the second encapsulating adhesive film prior to a lamination treatment. For the formed photovoltaic module after the lamination treatment, the concept of the first encapsulating adhesive film and the second encapsulating adhesive film no longer exists, that is, the first encapsulating adhesive film and the second encapsulating adhesive film have formed an integral encapsulating adhesive film 41.

In some embodiments, the cover plate 42 may be a cover plate having a light-transmitting function, such as a glass cover plate, a plastic cover plate, etc. Specifically, the surface of the cover plate 42 facing the encapsulating adhesive film 41 may be a concave-convex surface, so as to increase the utilization rate of the incident light. The cover plate 42 includes a first cover plate and a second cover plate. The first cover plate is opposite to the first encapsulating adhesive film. The second cover plate is opposite to the second encapsulating adhesive film.

According to the method for manufacturing a photovoltaic module in embodiments of the present disclosure, the second buffer adhesive films 104 are laid on the surfaces of the slicing cell sheets 101 at both sides of the cell string 40. This can reduce the force applied to the slicing cell sheets 101 at the edges during the series or parallel connection of the cell strings 40, thereby improving the reliability of the formed photovoltaic module. Besides, by laying the second buffer adhesive films 104 on the surfaces of the slicing cell sheets 101 at both sides of the cell string 40, after the photovoltaic module is formed, the slicing cell sheets 101 at the edges of the photovoltaic module are provided with the second buffer adhesive films 104, thereby reducing the possibility of damage to the edges of the photovoltaic module.

A yet another embodiment of the present disclosure further provides a photovoltaic module. The photovoltaic module may include the cell string manufactured by the method for manufacturing a cell string in some or all of the above embodiments, or be manufactured by the method for manufacturing a photovoltaic module in some or all of the above embodiments. The photovoltaic module provided in yet another embodiment of the present disclosure will be described below in conjunction with the drawings. It should be noted that the same or corresponding parts of the above embodiments can refer to the corresponding description of the above embodiments, which will not be repeated below.

Referring to FIGS. 4, 8, 10, 11, and 12, in some embodiments, the photovoltaic module can include: a cell string 40. The cell string 40 includes a plurality of slicing cell sheets, a first buffer adhesive film 102, and first welding strips 103. The first buffer adhesive film 102 is located on a surface of an end portion of a slicing cell sheet 101 adjacent to the next slicing cell sheet 101. The first welding strips 103 are electrically connected to at least two of the slicing cell sheets 101 to connect adjacent slicing cell sheets 101 in series. The adjacent slicing cell sheets 101 are partially overlapped. The first welding strips 103 cover the first buffer adhesive film 102 on the surface of the slicing cell sheet 101.

The photovoltaic module may further include at least one encapsulating adhesive film 41. The at least one encapsulating adhesive film 41 is configured to cover the surface of the cell string 40.

The photovoltaic module can further include a cover plate 42. The cover plate 42 is configured to cover the surface of the at least one encapsulating adhesive film 41 facing away from the cell string 40.

For the photovoltaic module, the first buffer adhesive film 102 is provided on the overlapping part of two adjacent slicing cell sheets 101 of the cell string 40 to reduce the interaction force between the two adjacent slicing cell sheets 101, thereby avoiding damage between the two adjacent slicing cell sheets 101 due to the interaction force, and improving the reliability of the photovoltaic module.

In some embodiments, the slicing cell sheets 101 are formed by cutting the same initial cell sheet. The slicing cell sheets 101 may be at least three slicing cell sheets 101 formed by cutting the same initial cell sheet at least twice. For the slicing cell sheets 101, the more the number of times of slicing the same initial cell sheet, the more likely the slicing cell sheets 101 are to be damaged due to the interaction force. Therefore, disposing the first buffer adhesive film 102 on the overlapping part of the slicing cell sheets 101 can effectively avoid this damage phenomenon.

In some embodiments, a width of the slicing cell sheet 101 may be 40 mm to 86 mm, for example, 61 mm, 65 mm, 70 mm, 76 mm, 77 mm, 79 mm, etc. A length of the slicing cell sheet 101 may be 180 mm to 260 mm, for example, 182.3 mm, 191 mm, 200 mm, 210 mm, 223 mm, 230 mm, 240 mm, etc.

In some embodiments, a plurality of solder joints 301 are provided on the slicing cell sheets 101, and the first welding strips 103 are in contact with plurality of solder joints 301.

In an arrangement direction of the slicing cell sheets 101 in the cell string 40, a width of the first buffer adhesive film 102 is less than a distance between the two nearest solder joints on adjacent slicing cell sheets 101. By providing the solder joints 301 on the slicing cell sheets 101, it can facilitate the connection between the slicing cell sheets 101 and the first welding strips 103. By setting the width of the first buffer adhesive film 102 to be less than the distance between the two nearest solder joints 301 of two adjacent slicing cell sheets 101, it can avoid the first buffer adhesive film 102 to cover the solder joints 301 on the slicing cell sheets 101, and can avoid the impact of the first buffer adhesive film 102 on the connection between the first welding strips 103 and the solder joints 301, thereby improving the reliability of the photovoltaic module.

In some embodiments, the distance between the two nearest solder joints on adjacent slicing cell sheets 101 may be 6 mm to 18 mm, for example, 7 mm, 8 mm, 12 mm, 16 mm, 17 mm, etc. It can be understood that the less the distance between the two nearest solder joints 301 on adjacent slicing cell sheets 101, the smaller the space reserved for disposing the first buffer adhesive film 102, resulting in increasing the difficulty of disposing the first buffer adhesive film 102, because the smaller the reserved space, the greater the difficulty of positioning. However, too far distance between the two nearest solder joints on adjacent slicing cell sheets 101 will reduce the reliability of the connection between the first welding strips 103 and the slicing cell sheets 101. Therefore, the distance between the two nearest solder joints of adjacent slicing cell sheets 101 is set to 6 mm to 18 mm, which not only considers the reliability of the connection between the first welding strips 103 and the slicing cell sheets 101, but also takes the space for disposing the first buffer adhesive film 102 into account.

In some embodiments, the first buffer adhesive film 102 protrudes from the end portion of the slicing cell sheet 101. It should be understood that the slicing cell sheet 101 has some edges, and the edges are more easily deformed and damaged when subjected to force compared with the surface of the slicing cell sheet 101. By disposing the first buffer adhesive film 102 to protrude from the end portion of the slicing cell sheet 101, the edges of the slicing cell sheet 101 can be protected by the first buffer adhesive film 102, thereby further improving the reliability of the photovoltaic module.

In an arrangement direction of the slicing cell sheets 101 in the cell string 40, a width of the first buffer adhesive film 102 ranges from 3 mm to 10 mm, for example, 4 mm, 5 mm, 6 mm, 7 mm, 8 mm, 9 mm, etc. In an arrangement direction perpendicular to the slicing cell sheets 101, a length of the first buffer adhesive film 102 ranges from 6 mm to 13 mm, for example, 7 mm, 8 mm, 9 mm, 10 mm, 11 mm, 12 mm, etc. As for the width and the length of the first buffer adhesive film 102, the larger the width and length of the first buffer adhesive film 102, the larger the area of the slicing cell sheet 101 that can be protected by the first buffer adhesive film 102. Similarly, the larger the width and length of the first buffer adhesive film 102, the higher the cost of the first buffer adhesive film 102, and the reliability of the connection between the slicing cell sheets 101 and the first welding strips 103 can be affected. Therefore, the width of the first buffer adhesive film 102 is set to 3 mm to 10 mm and the length of the first buffer adhesive film 102 is set to 6 mm to 13 mm, which can not only take into account the protection performance of the first buffer adhesive film 102, but also avoid the impact of the first buffer adhesive film 102 on the reliability of the cell string 40.

In some embodiments, the length of the first buffer adhesive film 102 may be less than the distance between two adjacent first welding strips 103 in the slicing cell sheet 101, thereby preventing the first buffer adhesive film 102 to affect the connection between the first welding strips 103 and the slicing cell sheets 101, thereby preventing the first buffer adhesive film 102 to affect the reliability of the photovoltaic module.

The length of the first buffer adhesive film 102 may be equal to the length of the slicing cell sheet 101. For the first buffer adhesive film 102, the longer the length of the first buffer adhesive film 102, the stronger the ability to protect the slicing cell sheet 101. By setting the length of the first buffer adhesive film 102 to be equal to the length of the slicing cell sheet 101, the edges and corners of the slicing cell sheet 101 can also be protected, thereby reducing the possibility of damage to the slicing cell sheet 101.

In some embodiments, the first buffer adhesive film 102 may be made from a pre-crosslinked film such as ethylene vinyl acetate copolymer (EVA), polyolefin elastomer (POE), EVA-POE-EVA co-extruded material (EPE), etc. By controlling the first buffer adhesive film 102 to be a pre-crosslinked film, the high temperature resistance of the first buffer adhesive film 102 can be improved, and the first buffer adhesive film 102 can be prevented from being affected in the entire process, thereby further improving the reliability of the formed cell string.

In some embodiments, the first buffer adhesive film 102 is made from an EVA material with a crosslinking degree of 5% to 70%, a POE material with a crosslinking degree of 5% to 70%, or a EPE material with a crosslinking degree of 5% to 70%.

It should be noted that the higher the crosslinking degree, the higher the cohesive strength of the first buffer adhesive film 102 and the tighter the bonding between the first buffer adhesive film 102 and the slicing cell sheet 101. However, the higher the crosslinking degree, the harder the first buffer adhesive film 102 material, which reduces the buffering capacity of the first buffer adhesive film 102. Therefore, by setting the crosslinking degree of the material to 5% to 70%, the reliability of the connection between the first buffer adhesive film 102 and the slicing cell sheet 101 can be improved while avoiding affecting the buffering capacity of the first buffer adhesive film 102.

Moreover, as for the cross-linking degree, the higher the cross-linking degree, the stronger the resistance to thermal aging of the material. When the welding strips 103 and the cell sheets are connected through high-temperature welding, the cross-linking degree of the first buffer adhesive film 102 material can be appropriately increased to avoid thermal aging of the first buffer adhesive film 102 during the manufacturing process and to avoid excessive impact on the lifetime of the first buffer adhesive film 102.

In some embodiments, the photovoltaic module can further include second buffer adhesive films 104, second welding strips 105, and busbars 106. The second buffer adhesive films 104 are located on surfaces of end portions of the slicing cell sheets 101 at both sides of the cell string 40. The second welding strips 105 are electrically connected to the slicing cell sheets 101 at both sides of the cell string 40, and cover surfaces of the second buffer adhesive films 104. The busbars 106 are electrically connected to the second welding strips 105 to be electrically connected to the plurality of cell strings 40 via the second welding strips 105. The second welding strips 105 are used to lead out the connection port of the circuit of the cell string 40, so as to facilitate the connection between the cell string 40 and the busbars 106. The busbars 106 are used to cooperate with the second welding strips 105 to connect different cell strings 40 in series or in parallel, so as to facilitate the control of the output voltage and the output current of the photovoltaic module. Besides, providing the second buffer adhesive films 104 can reduce the interaction force between the second welding strips 105 and the cell string 40, thereby reducing the impact on the slicing cell sheets 101 during the photovoltaic module manufacturing process of the photovoltaic module. Moreover, the second buffer adhesive film 104 can further reduce the force on the slicing cell sheet 101 at the edge of the photovoltaic module, thereby reducing the possibility of damage to the edges of the photovoltaic module.

In some embodiments, the second buffer adhesive film 104 protrudes from the end portion of the slicing cell sheet 101. First, the second buffer adhesive films 104 are located on surfaces of end portions of the slicing cell sheets 101 at both sides of the cell string 40. The slicing cell sheets 101 at both sides of the cell string 40 are those connected to the adjacent cell string 40 or those at the edges of the photovoltaic module, which are more likely to be abnormal such as deformation or breakage. Therefore, by arranging the second buffer adhesive film 104 to protrude from the end portion of the slicing cell sheet 101, the slicing cell sheets 101 at both sides of the cell string 40 can be further protected, thereby improving the reliability of the photovoltaic module.

As for the second buffer adhesive film 104, the size of the second buffer adhesive film 104 can be consistent with the size of the first buffer adhesive film 102, thereby reducing the difficulty of the photovoltaic module manufacturing process.

Alternatively, the size of the second buffer adhesive film 104 can be larger than the size of the first buffer adhesive film 102. Since the second buffer adhesive film 104 is disposed between the cell strings, increasing the size of the second buffer adhesive film 104 can not only ensure that the second buffer adhesive film 104 can provide sufficient buffering capacity, but also separate the cell string from the edge of the photovoltaic module, thereby further protecting the cell string 40.

The second buffer adhesive film 104 has a width ranging from 4 mm to 15 mm. The second buffer adhesive film 104 has a width ranging from 6 nm to 20 nm. By setting the width of the second buffer adhesive film 104 to be 4 mm to 15 mm and the length to be 6 nm to 20 nm, the protection performance of the second buffer adhesive film 104 can be taken into consideration while preventing the second buffer adhesive film 104 to affect the reliability of the photovoltaic module.

It can be understood by those skilled in the art that the above-mentioned embodiments are only specific implementations of the present disclosure, and various changes can be made in form and in detail in practical applications without departing from the scope of the embodiments of the present disclosure. Various changes and modifications can be made by those skilled in the art without departing from the scope of the embodiments of the present disclosure. Therefore, the protection scope of the embodiments of the present disclosure shall be defined by the appended claims.

## Claims

1. A method for manufacturing a cell string, comprising:
providing a plurality of slicing cell sheets (101) to be stacked, wherein the plurality of slicing cell sheets (101) include a first slicing cell sheet (1011) and a second slicing cell sheet (1012), at least one surface of the first slicing cell sheet (1011) has a stacking area (30) to be stacked with the second slicing cell sheet (1012), and a first buffer adhesive film (102) is laid in the stacking area (30);
laying first welding strips (103) on the at least one surface of the first slicing cell sheet (1011), with the first welding strips (103) passing through the stacking area (30) and covering a part of the first buffer adhesive film (102);
partially stacking the second slicing cell sheet (1012) with the first slicing cell sheet (1011); and performing welding such that the second slicing cell sheet (1012) is electrically interconnected with the first slicing cell sheet (1011) via the first welding strips (103).

2. The manufacturing method according to claim 1, wherein in an arrangement direction of the plurality of slicing cell sheets (101) in the cell string (40), the first buffer adhesive film (102) has a width greater than or equal to a width of the stacking area (30).

3. The manufacturing method according to any one of claims 1 to 2, wherein in an arrangement direction of the plurality of slicing cell sheets (101) in the cell string (40), the first buffer adhesive film (102) protrudes from an end portion of the first slicing cell sheet (1011).

4. The manufacturing method according to any one of claims 1 to 3, wherein in an arrangement direction of the plurality of slicing cell sheets (101) in the cell string (40), the first buffer adhesive film (102) has a width ranging from 3 mm to 10 mm; and in a direction perpendicular to the arrangement direction of the plurality of slicing cell sheets (101), the first buffer adhesive film (102) has a length ranging from 6 mm to 13 mm.

5. The manufacturing method according to any one of claims 1 to 4, further including:
before laying the first welding strips (103) on the surface of the first slicing cell sheet (1011), performing a heat fixing treatment on the first buffer adhesive film (102), wherein the heat fixing treatment includes heating the first buffer adhesive film (102) to bond the first buffer adhesive film (102) on the surface of the first slicing cell sheet (1011);
optionally, wherein process parameters of the heat fixing treatment include: a heating temperature ranging from 60°C to 70°C and a heating time period ranging from 0.5 s to 1.5 s.

6. The manufacturing method according to any one of claims 1 to 5, wherein the welding includes laser welding, and the laser welding includes: controlling a laser to irradiate a surface of the first welding strips (103) to weld the first welding strips (103) to surfaces of the slicing cell sheets.

7. The manufacturing method according to any one of claims 1 to 6, the method further includes: providing a plurality of solder joints (301) on the slicing cell sheets, wherein the first welding strips (103) are in contact with the plurality of solder joints (301), and in an arrangement direction of the slicing cell sheets (101) in the cell string (40), a width of the first buffer adhesive film (102) is less than a distance between the two nearest solder joints (301) of the first and second slicing cell sheets (1012).

8. The manufacturing method according to any one of claims 1 to 7, wherein a respective first welding strip of the first welding strips (103) includes a main portion (1031) and a connecting portion (1032) connecting the main portion (1031), wherein the main portion (1031) has a thickness greater than a thickness of the connecting portion;
the laying of the first welding strips (103) on the at least one surface of the first slicing cell sheet (1011) includes:
positioning the connecting portion (1032) to be directly aligned with the first buffer adhesive film (102);
optionally, wherein a sum of the thickness of the connecting portion (1032) and a thickness of the first buffer adhesive film (102) is equal to the thickness of the main portion (1031).

9. The manufacturing method according to any one of claims 1 to 8, wherein the first buffer adhesive film (102) may be made from a pre-crosslinked adhesive film such as Ethylene Vinyl Acetate Copolymer (EVA), Polyolefin Elastomer (POE), or a co-extruded material of EVA-POE-EVA (EPE);
optionally, wherein the first buffer adhesive film (102) is made from an Ethylene Vinyl Acetate Copolymer (EVA) material with a crosslinking degree of 5% to 70%, a Polyolefin Elastomer (POE) material with a crosslinking degree of 5% to 70%, or an EVA-POE-EVA (EPE) material with a crosslinking degree of 5% to 70%.

10. The manufacturing method according to any one of claims 1 to 9, wherein a respective slicing cell sheet of the plurality of slicing cell sheets (101) is a 3-segmented to a 12-segmented cell obtained by cutting an original whole cell sheet into 3 to 12 segments.

11. The manufacturing method according to any one of claims 1 to 9, wherein a width of a respective of the plurality of slicing cell sheets (101) ranges from 40 to 86 mm, a length of a respective of the plurality of slicing cell sheets ranges from 180 to 260 mm.

12. The manufacturing method according to any one of claims 1 to 9, wherein the laying of the first buffer adhesive film (102) includes:
providing an initial buffer adhesive film;
cutting the initial buffer adhesive film to form the first buffer adhesive film (102); and
moving the first buffer adhesive film (102) to the stacking area (30).

13. The manufacturing method according to any one of claims 1 to 9, wherein the first slicing cell sheet (1011) includes a first surface (10) and a second surface (20) opposite to the first surface (10), the laying of the first buffer adhesive film (102) comprises:
laying the first buffer adhesive film (102) in the stacking area (30) corresponding to the first surface (10) and the second surface (20).

14. The manufacturing method according to any one of claims 1 to 9, wherein the first slicing cell sheet (1011) is formed by:
providing an initial cell sheet;
cutting the initial cell sheet to form at least three cell slices; and
laying the first buffer adhesive film (102) in the stacking area (30) of a respective cell slice of the at least three cell slices to form the first slicing cell sheet (1011);
or,
providing an initial cell sheet;
laying the first buffer adhesive film (102) in the stacking area (30) of the initial cell sheet corresponding to each slicing cell sheet; and
cutting the initial cell sheet with the first buffer adhesive film (102) laid thereon to form at least three first slicing cell sheets (1011).

15. A method for manufacturing a photovoltaic module, comprising:
providing a plurality of cell strings, wherein a respective cell string of the plurality of cell strings is the cell string (40) manufactured by the method according to any one of claims 1 to 14;
laying second buffer adhesive films (104) on surfaces of the slicing cell sheets (101) at both sides of the respective cell string, the second buffer adhesive films (104) being located at end portions of the slicing cell sheets (101);
providing second welding strips (105), the second welding strips (105) being electrically connected to the slicing cell sheets (101) at both sides of the respective cell string and covering surfaces of the second buffer adhesive films (104);
providing busbars (106), the busbars (106) being electrically connected to the second welding strips (105) and electrically connected to the plurality of cell strings (40) via the second welding strips (105);
forming at least one encapsulating adhesive film (41), the at least one encapsulating adhesive film (41) being configured to cover surfaces of the plurality of cell strings (40); and
forming a cover plate (42), the cover plate (42) being configured to cover a surface of the at least one encapsulating adhesive film (41) facing away from the plurality of cell strings (40).
